Europäisches Patentamt

European Patent Office

Office européen des brevets

(19)

(11) Veröffentlichungsnummer: **0 070 501**
**A2**

(12) # EUROPÄISCHE PATENTANMELDUNG

(21) Anmeldenummer: **82106264.3**

(22) Anmeldetag: **13.07.82**

(51) Int. Cl.³: **H 01 L 33/00**

(30) Priorität: **17.07.81 DE 3128378**

(43) Veröffentlichungstag der Anmeldung: **26.01.83**
**Patentblatt 83/4**

(84) Benannte Vertragsstaaten: **FR GB IT**

(71) Anmelder: **SIEMENS AKTIENGESELLSCHAFT, Berlin und München Wittelsbacherplatz 2, D-8000 München 2 (DE)**

(72) Erfinder: **Heinen, Jochen, Dr., Dianastrasse 38, D-8013 Haar (DE)**

(54) **Verfahren zur Herstellung einer Lumineszenzdiode mit sphärischer Oberfläche.**

(57) Verfahren zur Herstellung einer Lumineszenzdiode mit einem Flächenanteil (114), der im wesentlichen die Form einer Kugelkalotte hat, um das von der Leuchtfläche (3) der Diode in den Raumwinkel gestrahlte Licht zu bündeln. Das Verfahren wird mit nur zwei aufeinanderfolgenden Ätzschritten durchgeführt, bei dem nur im ersten Ätzschritt eine Ätzmaske (10) benötigt wird.

EP 0 070 501 A2

SIEMENS AKTIENGESELLSCHAFT
Berlin und München

Unser Zeichen
VPA 81 P 7 0 8 0 E

0070501

**Verfahren zur Herstellung einer Lumineszenzdiode mit sphärischer Oberfläche.**

Die vorliegende Erfindung bezieht sich auf ein Verfahren zur Herstellung einer wenigstens im wesentlichen sphärischen Oberfläche an dem Halbleiterkörper einer Lumineszenzdiode, wie im Oberbegriff des Patentanspruchs 1 näher angegeben.

Seit fast zwei Jahrzehnten ist es bekannt, im Zusammenhang mit einer Lumineszenzdiode eine optische sphärische Fläche zu verwenden, um das von der Lumineszenzdiode in den Raumwinkel ausgesandte Licht mehr oder weniger stark in eine Vorzugsrichtung zu bündeln. Es ist das Prinzip der Weierstraß-Kugel bekannt. Diesem Prinzip entsprechend wird von einer punktförmig gedachten Lichtquelle in den Raumwinkel ausgehende Strahlung in parallelgerichtete Strahlung abgelenkt.

Im Laufe der Entwicklung von Lumineszenzdioden hat man seit Jahren Versuche angestellt und auch in die Praxis umgesetzt, möglichst weitgehend angenähert dieses Prinzip zu realisieren. Relativ frühe Vorschläge bestanden darin, auf den Halbleiterkörper der Lumineszenzdiode eine kleine mehr oder weniger exakt kugelförmige Linse aufzusetzen, die diese Bündelungsfunktion erfüllt. Es ist überraschend, daß ein solcher Vorschlag auch derzeit noch immer wieder praktiziert wird, obwohl der Aufwand zu seiner Verwirklichung extrem hoch ist. Dies ist allein schon aus den Größenverhältnissen ersichtlich, nachdem eine derartige Lumineszenz-

Bts 1 Bla / 13.7.1981

0070501
81 P 7080 E

diode eine Größe hat, die - soweit es die eigentliche Funktion betrifft - kaum 100 /um Längenabmessung übertrifft.

Sehr frühzeitig sind bereits auch schon solche Vorschläge gemacht worden, bereits dem Halbleiterkörper der Lumineszenzdiode eine solche Form zu geben, die wenigstens in gewissem Maße an eine sphärische Fläche angenähert ist. Für eine entsprechende Bearbeitung des Halbleiterkörpers kommt überwiegend das Ätzen in Betracht. Man hat solche Dioden z.B. in der Weise hergestellt, daß man auf der Oberfläche des Halbleitermaterials eine kreisrunde Schicht aufgebracht hat, die bei nachfolgender Behandlung die Form eines angenähert kugelförmigen Tropfens annimmt. Durch nachfolgendes Ionenätzen hat man dann die Struktur dieses Tropfens auf das Halbleitermaterial übertragen. Der Aufwand zur Durchführung dieses Verfahrens ist beträchtlich.

Ein anderes Verfahren, das zu einer kuppelförmigen Erhebung über der Leuchtfläche der Diode führt, ist dasjenige, bei dem programmgesteuertes Ionenätzen und/oder Elektronenätzen angewendet wird. Dieses Verfahren ist insbesondere von der apparativen Seite her sehr aufwendig, und prinzipiell muß jede einzelne Diode für sich programmgesteuert hergestellt werden.

Ein noch weiteres bekanntes Verfahren ist, zunächst in einen Substratkörper eine kugelkalottenförmige Vertiefung hereinzuätzen, dann auf diesem Körper die Schichten der Diode epitaktisch aufwachsen zu lassen und den Substratkörper nachfolgend abzuätzen.

Des weiteren sind auch Vorschläge gemacht worden, nicht die Diode, sondern das der Diode gegenüberstehende Ende der Glasfaser mit einer entsprechenden sphärischen Fläche zu versehen, die das in den Raumwinkel von der Diode ausgestrahlte Licht in gleicher Weise in der Glasfaser bündelt. Bei diesem Verfahren werden die Enden der einzelnen Glasfaser durch Anschmelzen verrundet, wobei Schwierigkeiten insbesondere darin bestehen, eine wenigstens einigermaßen angenähert sphärische Fläche mit vor allem passendem Krümmungsradius zu erhalten.

Es ist eine Aufgabe der vorliegenden Erfindung, ein technologisch einfaches Verfahren anzugeben, mit dessen Hilfe der Halbleiterkörper einer Lumineszenzdiode durch Ätzen mit einer solchen Oberfläche versehen werden kann, die einer sphärischen Fläche wenigstens weitgehend angenähert ist. Insbesondere soll dieses Verfahren für die Massenproduktion geeignet sein, bei der eine Vielzahl von Lumineszenzdioden zunächst in jeweils einem Halbleiterkörper hergestellt wird, der dann in die einzelnen Dioden zerteilt werden kann.

Diese Aufgabe wird für ein Verfahren nach dem Oberbegriff des Patentanspruchs 1 erfindungsgemäß mit den Merkmalen des Kennzeichens dieses Patentanspruchs 1 gelöst. Weitere Ausgestaltungen und Weiterbildungen der Erfindung gehen aus den Unteransprüchen hervor.

Mit dem erfindungsgemäßen Verfahren erreicht man überraschenderweise mit bereits nur zwei Ätzschritten eine die Anforderungen ohne weiteres erfüllende, angenähert sphärische Oberfläche bzw. wenigstens angenähert eine Kugelkalotte. Dabei ist ein entscheidender Vorteil des erfindungsgemäßen Verfahrens, daß nur ein einziges Mal eine Maske verwendet werden muß und daß nicht nur lediglich ein einziger weiterer Ätzprozeß durchzuführen ist, sondern daß für diesen Ätzprozeß außerdem auch keine weitere Maskenjustierung oder dergleichen erforderlich ist.

Das im ersten erfindungsgemäß vorgesehenen Ätzschritt durchzuführende Ätzen einer Mesa-Struktur ist für sich genommen bekannt. Es wird dazu eine eine kreisrunde Fläche abdeckende Maske verwendet. Das Ätzen erfolgt mit einem wenigstens weitgehend isotrop ätzenden Mittel, wie z.B. Brommethanol. Das Halbleitermaterial der Lumineszenzdiode ist ein III-V-Halbleitermaterial, wie insbesondere Galliumarsenid, Galliumarsenid-Phosphid, Galliumaluminium-Arsenid, Indiumphosphid und so weiter. Es können auch Halbleiterkörper aus voneinander verschiedenartigen Materialien bestehend vorgesehen sein. Für das erfindungsgemäße Verfahren hat dies lediglich in Bezug auf die Auswahl eines zweckmäßigen Ätzmittels aus den zahlreichen bekannten Ätzmitteln einen Einfluß.

Weitere Einzelheiten zum Verständnis der Erfindung werden zweckmäßigerweise anhand der beigefügten Figuren erläutert.

Fig.1 zeigt eine prinzipielle Darstellung zur Durchführung des erfindungsgemäßen Verfahrens.

Fig.2 zeigt eine weitere Ausführungsform einer nach dem erfindungsgemäßen Verfahren hergestellten Lumineszenzdiode.

Fig.3 zeigt eine Erläuterung zum besseren Verständnis der erreichten Bündelung.

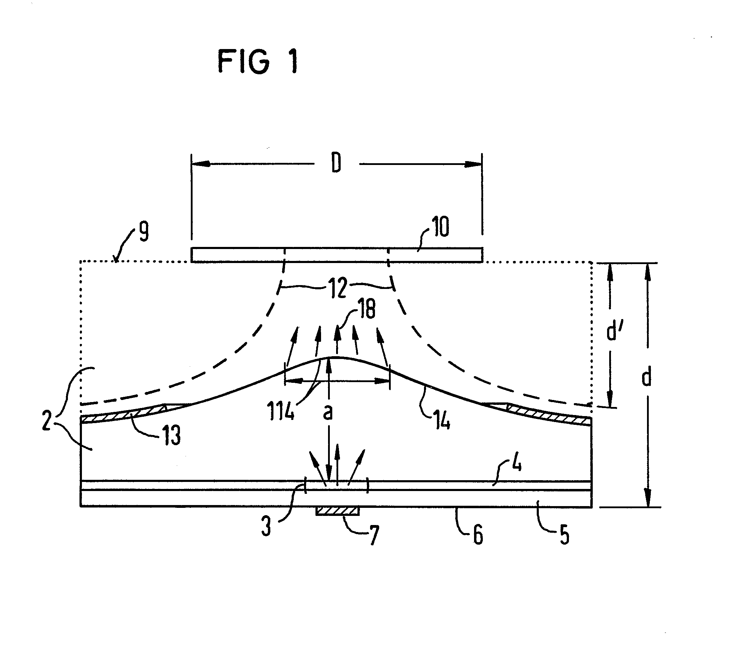

Mit gepunktet wiedergegebenen Linien bzw. Bruchkanten ist ein als Ausgangsmaterial dienender Halbleiterkörper 2 aus beispielsweise Indiumphosphid dargestellt. Ein mit 3 bezeichneter Bereich des Halbleiterkörpers ist entweder bereits hergestellt oder für eine spätere Realisierung als Leuchtfläche definiert. Dieser Bereich 3 liegt in einer Struktur aus den Schichten 4 und 5, die einen an sich bekannten PN-Übergang im Bereich nahe der (in der Fig.1 unteren) Oberflächenseite 6 des Halbleiterkörpers 2 bilden. Mit 7 ist ein elektrischer Kontakt bezeichnet, der wie an sich bekannterweise auf die laterale Begrenzung der Leuchtfläche 3 einwirkt. Mit den Pfeilen 8 ist die in den Raumwinkel bekanntermaßen erfolgende Ausstrahlung aus der Leuchtfläche 3 der Lumineszenzdiode kenntlich gemacht.

Der Oberflächenseite 6 des Halbleiterkörpers 2 gegenüberliegend, d.h. der eigentlichen Lumineszenzdiode gegenüberliegend, wird im Rahmen des ersten Schrittes des erfindungsgemäßen Verfahrens auf der Oberflächenseite 9 dieses Halbleiterkörpers 2 eine Ätzmaske 10 aufgebracht. Sie hat eine kreisrunde Form. Bezogen auf einen Halbleiterkörper 2 mit einer im Rahmen des Üblichen liegenden Dicke von 100 μm ist die Ätzmaske 10 im Rahmen der Erfindung mit einem Durchmesser D von ungefähr 100 μm zu bemessen. Die Ätzmaske 10 kann eine fotolithografische Schicht bzw. eine Fotomaske oder z.B. eine Metallmaske sein.

Im ersten Verfahrensschritt werden diejenigen Anteile des Halbleiterkörpers 2 entfernt, die in (der Schnittdarstellung) der Fig.1 zwischen der ursprünglichen (punktierten) Umrandung des Halbleiterkörpers 2 und der gestrichelt dargestellten Oberfläche 12 der entstandenen Mesa-Struktur liegen. Wie ersichtlich, hat infolge des Unterätzens des isotrop ätzenden Ätzmittels die Mesa-Struktur 12 einen Durchmesser des Mesa von ungefähr

0070501

81 P 7080 E

nur noch 30 /um (gegenüber den 100 /um der Ätzmaske 10). Das Ätzen des ersten Verfahrensschrittes, das zur Erzeugung der Mesa-Struktur 12 führt, ergibt tatsächlich eine wie angegebene symmetrische Form.

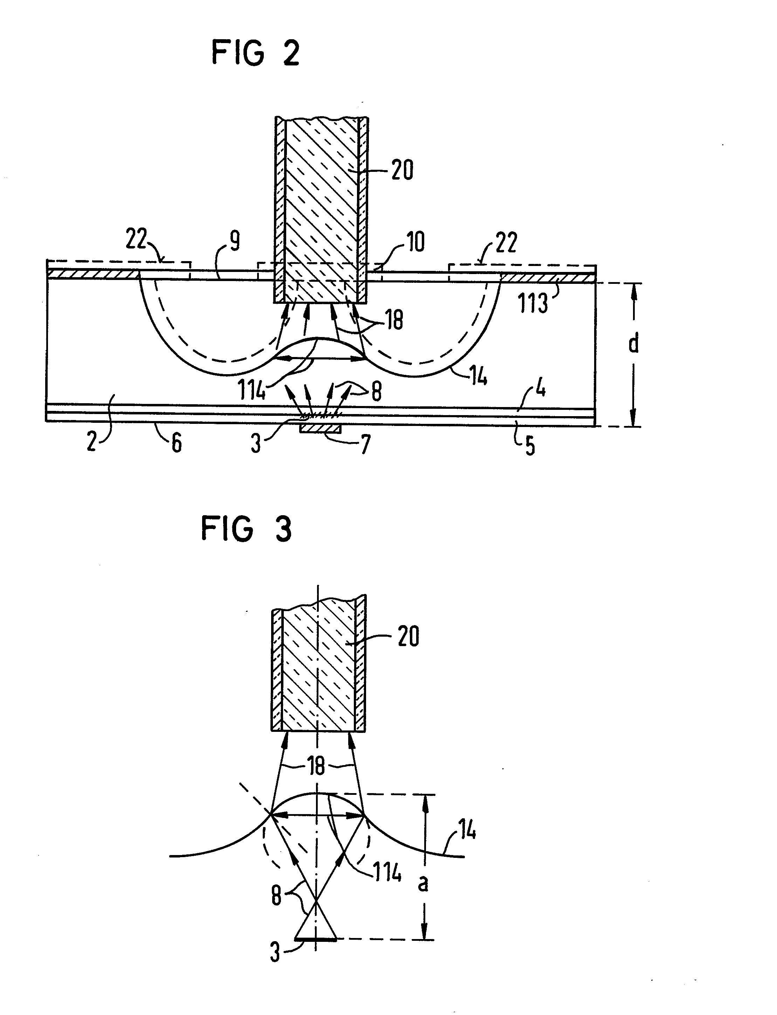

Für den zweiten Ätzschritt wird zunächst die noch vorhandene Ätzmaske 10 entfernt. In diesem Ätzschritt wird wiederum isotrop geätzt, jedoch nunmehr ohne die Notwendigkeit der Verwendung einer Ätzmaske, die nämlich zwangsläufig auch zu justieren wäre. Dieser zweite Ätzvorgang führt zu der (in der Schnittdarstellung) mit 14 bezeichneten Fläche, die auch die endgültige Oberfläche der nach dem erfindungsgemäßen Verfahren hergestellten Lumineszenzdiode ist. Wie ersichtlich, erfolgt trotz der Verwendung eines wenigstens im wesentlichen isotrop ätzenden Ätzmittels ein wesentlich stärkeres Abtragen der Spitze der Mesa-Struktur 12. Überraschenderweise läßt sich das erfindungsgemäße Verfahren so dimensionieren, daß tatsächlich bereits mit dem zweiten Ätzschritt für einen Bereich der Oberfläche 14 die geforderte, wenigstens annähernd sphärische Oberfläche 114 entsteht. Es ist dabei zu berücksichtigen, daß diese sphärische Oberfläche nur für einen zentralen Bereich 114 der erfindungsgemäß hergestellten Lumineszenzdiode erforderlich ist. Eine nach dem erfindungsgemäßen Verfahren hergestellte Lumineszenzdiode ist dazu vorgesehen, im Zusammenhang mit einer Glasfaser verwendet zu werden, in die die aus der Leuchtfläche 3 austretende Strahlung 8 zu bündeln ist, wie dies in der noch zu beschreibenden Fig.2 angedeutet ist. Mit 18 ist dort die gebündelte Strahlung und mit 20 die Glasfaser bezeichnet, in die die Strahlung 18 so einzukoppeln ist, daß möglichst großer Gewinn eintritt.

Mit 13 ist in Fig.1 eine beispielsweise ringförmige Elektrode bezeichnet, die als Gegenelektrode zum Kontakt 7 dient.

Bereits oben ist auf Abmessungsverhältnisse hingewiesen. Übliche Abmessungen der Leuchtfläche einer einschlägigen Lumineszenzdiode betragen 20 bis 50 μm (Durchmesser). Der Kerndurchmesser einer Glasfaser 20 beträgt im Regelfall 50 bis 60 μm. Wesentlich größer als dieser Kerndurchmesser braucht der Durchmesser desjenigen Bereiches 114 nicht zu sein, in dem die Oberfläche 14 die wenigstens weitgehend angenäherte sphärische Form hat bzw. eine Kugelkalotte bildet. Außerhalb liegende Bereiche der Oberfläche 14 können wie in den Figuren ersichtlich in die Form einer Plattenstruktur auslaufen. Der Krümmungsradius des (nahezu) sphärischen Bereiches 114 der Oberfläche hat für die vorgegebene Leuchtfläche 3 einen bekannten und damit vorgegebenen Wert. Für einen Abstand a zwischen sphärischer Fläche 114 und Leuchtfläche 3 in der Größe von etwa 100 μm beträgt – damit gebündelte (siehe Fig.3) Strahlung 18 austritt – der Krümmungsradius für die geätzte Fläche 114 etwa 70 μm. Für a ungefähr 50 μm ist der entsprechende Wert 36 μm. Für einen Wert a = 100 μm ist die Dicke d des ursprünglichen Halbleiterkörpers 2 etwa 140 μm, und im ersten Ätzschritt wird weit außerhalb der Maske 10 um eine Tiefe von etwa d' = 50 μm abgeätzt.

Für die im Rahmen der vorliegenden Erfindung durchzuführende Bemessung des Durchmessers D der Ätzmaske 10, abhängig von der Dicke des Ausgangskörpers 2, und für die Bemessung der Ätzzeiten für beide Ätzschritte kann man aus den bekannten Daten für die Ätzgeschwindigkeit eines bestimmten Ätzmittels bei einem bestimmten der in Frage kommenden Halbleitermaterialien zumindest mit einem Rechner ermittelte mathematische Beziehungen angeben. Es

0070501
81 P 7 0 8 0 E

wäre dies aber bereits ein unnotwendig großer Aufwand, nachdem sich diese Bemessungen im Rahmen der Erfindung in einfacher Weise rasch durch einige Versuche ermitteln lassen (wie dies auch zum Entstehen der Erfindung, und zwar mit bereits vorhandener Kenntnis des Erfindungsgedankens tatsächlich erfolgt ist).

Die Fig.2 zeigt eine Lumineszenzdiode mit einer für Fälle mit besonders kleinem Krümmungsradius besonders geeigneten Form, die zwar komplizierter erscheint, jedoch mit dem gleichen geringen Aufwand zu realisieren ist, mit dem eine Lumineszenzdiode nach der Fig.1 herzustellen ist. Das Herstellungsverfahren der Diode nach Fig.2 ist gleich demjenigen der Diode nach Fig.1, mit der Ausnahme, daß konzentrisch zur Ätzmaske 10 dort noch eine weitere ringförmige Abdeckmaske 22 verwendet wird. Diese Maske 22 hat aber mit dem eigentlichen erfindungsgemäßen Verfahren zur Erzeugung der Fläche 114 nichts zu tun. Diese Maske 22 dient dazu, außerhalb der eigentlichen Lumineszenzdiode bzw. weit außerhalb ihrer Leuchtfläche 3 liegende Anteile des Halbleiterkörpers 2 derart abzudecken, daß die beiden erfindungsgemäßen Ätzschritte dort kein Halbleitermaterial mehr abtragen. Es bleibt dort die ursprüngliche Dicke des plättchenförmigen Halbleiterkörpers 2 erhalten. Dies führt zu einer mechanisch stabilen Ausführungsform einer erfindungsgemäß hergestellten Lumineszenzdiode. Diese zusätzliche Abdeckmaske 22 bleibt während beider Ätzschritte auf der betreffenden Oberfläche des Halbleiterkörpers 2. Die erfindungsnotwendig zu verwendende Abdeckmaske 10 ist in der Fig.2 gestrichelt dargestellt. Ebenfalls (wieder) gestrichelt ist die Mesa-Struktur 12 des ersten Verfahrensschrittes angegeben. Mit 14 ist auch in Fig.2 die mit dem zweiten Ätzschritt entstehende endgültige Struktur der Diode bezeichnet, die wieder einen wenigstens nahezu sphärischen Bereich 114 aufweist. Bezüglich weiterer Einzelheiten und Bezugszeichen zur Ausführungsform nach Fig.2 sei auf die Beschreibung zur Fig.1 hingewiesen.

Die während des Herstellungsverfahrens mit der Maske 22 abgedeckte Oberfläche des Halbleiterkörpers 2 wird schließlich mit der zweiten notwendigen Elektrode 113, vergleichsweise der Elektrode 13, versehen

Fig.3 zeigt eine Darstellung der erreichten optischen Bündelung, und zwar für zwei Strahlen 8, die von jeweils einem Randpunkt der Leuchtfläche 3 ausgehen. Sie werden von der kugelkalottenförmigen Oberfläche 114, die sich über den mit dem zugehörigen Doppelpfeil kenntlich gemachten Anteil der Fläche 14 erstreckt, als Strahlung 18 gerade noch in den lichtleitenden Kern der Faser 20 gebrochen. Von diesen Randpunkten und von mittleren Punkten der Leuchtfläche 3 (mit Richtungen näher der Flächennormalen) ausgehende (und in dem Flächenanteil 114 hindurchtretende) Strahlen 8 gelangen mit entsprechender Brechung in den Kern der Faser 20. Es ist ersichtlich, daß bei einer planen Fläche anstelle der Fläche 114 nur ein kleiner Bruchteil der von der Fläche 3 in den Raumwinkel ausgehenden Strahlen 8 im Querschnittsbereich des Kerns der Faser 20 auftreffen würden.

0070501
81 P 7080 E

Patentansprüche:

1. Verfahren zur Herstellung einer wenigstens im wesentlichen sphärischen Fläche an dem Halbleiterkörper einer Lumineszenzdiode, die insbesondere für eine optische Ankopplung an eine Glasfaserleitung vorgesehen ist, wobei der Halbleiterkörper auf der der eigentlichen Lumineszenzdiode gegenüberliegenden Fläche, dieser Lumineszenzdiode gegenüberliegend, mit einer kreisrunden Schicht bedeckt und dann der Halbleiterkörper geätzt wird, g e k e n n z e i c h n e t  dadurch, daß für die Erzeugung dieser Fläche diese Schicht als Ätzmaske vorgesehen ist, die nur in einem ersten Ätzschritt verwendet wird, wobei in diesem Ätzschritt eine Mesa-Struktur des Halbleiterkörpers (2) hergestellt wird, und dadurch, daß ein zweiter Ätzschritt durchgeführt wird, in dem die entstandene Mesa-Spitze dieser Struktur (12) bis zum Entstehen der im wesentlichen sphärischen Fläche (114) abgetragen wird, wobei der Durchmesser (D) der Ätzmaske (10) auf die ursprüngliche Dicke (d) des Halbleiterkörpers (2) und die endgültige Höhe (a) derart abgestimmt bemessen ist, daß der im ersten Ätzschritt erzeugte Mesa nach dem zweiten Ätzschritt die im wesentlichen sphärische Fläche (114) mit dem vorgegebenen Radius ergibt.

2. Verfahren nach Anspruch 1, g e k e n n z e i c h n e t  dadurch, daß eine weitere Maske (22) im ersten und im zweiten Ätzschritt verwendet wird, mit der außerhalb des Bereiches, in dem die im wesentlichen sphärische Fläche (114) herzustellen ist, Halbleitermaterial des Halbleiterkörpers (2) zum Verbleiben einer Randverstärkung abgedeckt wird.

FIG 1

FIG 2

FIG 3